(19)

**Europäisches Patentamt**

**European Patent Office**

**Office européen des brevets**

(11) **EP 4 567 895 A1**

(12) **EUROPEAN PATENT APPLICATION**

(43) Date of publication:
**11.06.2025   Bulletin 2025/24**

(21) Application number: **23215319.7**

(22) Date of filing: **08.12.2023**

(51) International Patent Classification (IPC):
*H01L 29/06* (2006.01)    *H01L 21/761* (2006.01)
*H01L 29/10* (2006.01)    *H01L 29/423* (2006.01)
*H01L 29/78* (2006.01)

(52) Cooperative Patent Classification (CPC):
**H10D 30/655; H01L 21/761; H10D 62/127;**
**H10D 62/378; H10D 62/393; H10D 64/516;**
H10D 62/116; H10D 64/519

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **Infineon Technologies Dresden GmbH**
**& Co . KG**
**01099 Dresden (DE)**

(72) Inventors:
• **WEIS, Rolf**
  **01109 Dresden (DE)**
• **MAHMOUD, Ahmed**
  **85345 Freising (DE)**
• **FEICK, Henning**
  **81547 München (DE)**
• **RESO, Denis**
  **01445 Radebeul (DE)**

(74) Representative: **Westphal, Mussgnug  & Partner,**
**Patentanwälte mbB**
**Werinherstraße 79**
**81541 München (DE)**

(54) **ELECTRONIC CIRCUIT INCLUDING A LEVEL SHIFTER**

(57)     An electronic circuit and an integrated circuit are disclosed. The electronic circuit includes: a level shifter (2) comprising a level shifter transistor (TL1) having a load path coupled between a low-side reference node (N11) and a high-side supply node (N13) of the electronic circuit (1). The electronic circuit further includes a semiconductor body (100) having a base region (110) of a first doping type, a tub (120) of a second doping type complementary to the first doping type, and a device region (130) of the first doping separated from the base region (110) by the tub (120). The level shifter transistor (TL1) is at least partially integrated in the device region (130), and the tub (120) is connected to the high-side supply node (N13) and the base region (110) is connected to the low-side reference node (N11).

FIG 1

## EP 4 567 895 A1

**Description**

This disclosure relates in general to an electronic circuit including a level shifter.

A level shifter is used to transmit signals from a first voltage domain to a second voltage domain different from the first voltage domain. In particular, a level shifter may be used to transmit a control signals that are referenced to a first reference potential, such as ground potential, to a drive circuit of a high-side switch. Usually, the drive circuit receives a supply voltage that is referenced to a second reference potential different from the first reference potential and is configured to generate a drive signal for the high-side switch that is referenced to the second reference potential.

There is a need for an electronic circuit with a level shifter that is capable of transmitting a signal fast and in a reliable manner.

One example relates to an electronic circuit. The electronic circuit includes a level shifter with a level shifter transistor having a load path coupled between a low-side reference node and a high-side supply node of the electronic circuit. The electronic circuit further includes a semiconductor body having a base region of a first doping type, a tub of a second doping type complementary to the first doping type, and a device region of the first doping separated from the base region by the tub. The level shifter transistor is at least partially integrated in the device region. The tub is connected to the high-side supply node, and the base region is connected to the low-side reference node.

Another example relates to an integrated circuit. The integrated circuit includes a semiconductor body having a base region of a first doping type, a tub of a second doping type complementary to the first doping type, and a device region of the first doping separated from the base region by the tub. The integrated circuit further includes a transistor that is at least partially integrated in the device region, wherein the transistor includes a drift region of the second doping type, a drain region of the second doping type adjoining the drift region, a body region of the first doping type adjoining the drift region spaced apart from the drain region, a source region of the second doping type separated from the drift region by the body region, and a gate electrode adjacent to the body region and dielectrically insulated from the body region by a gate dielectric. The body region, in a horizontal plane of the semiconductor body, forms a closed loop around the drain region, and the drift region is spaced apart from the body region in at least one of a first and second edge region of the transistor.

Examples are explained below with reference to the drawings. The drawings serve to illustrate certain principles, so that only aspects necessary for understanding these principles are illustrated. The drawings are not to scale. In the drawings the same reference characters denote like features.

Figure 1 illustrates one example of an electronic circuit that includes a level shifter with a level shifter transistor;

Figures 2A-2B illustrate one example for at least partially integrating the level shifter transistor in a semiconductor body;

Figure 3 illustrates a load circuit with a high-side switch that is driven by the electronic circuit according to Figure 1;

Figure 4 shows a vertical cross-sectional view of a semiconductor body to illustrate one example for at least partially integrating the level shifter transistor in the semiconductor body;

Figure 5 shows a top view of the semiconductor body according to Figure 3;

Figure 6 shows a vertical cross-sectional view of one section of the semiconductor body to illustrate a modification of the level shifter transistor according to Figure 4;

Figure 7 shows a top view of one section of the semiconductor body to illustrate a level shifter transistor according to another example;

Figures 8A-8B illustrate a level shifter transistor according to another example;

Figure 9 illustrates a modification of the level shifter transistor according to Figures 8A-8B;

Figures 10A-10B illustrate a level shifter transistor according to another example, which is a modification of the level shifter transistor according to Figures 8A-8B;

Figure 11 illustrates one example of a level shifter that includes a level shifter transistor and an evaluation circuit connected in series with the level shifter transistor;

Figure 12 illustrates one example of the evaluation circuit greater detail;

Figure 13 illustrates one example of a level shifter that includes two level shifter transistors;

Figure 14 illustrates one example for at least partially integrating the two level shifter transistors in one doped tub of a semiconductor body;

Figure 15 illustrates one example of a high-side drive circuit included in the electronic circuit;

Figure 16 illustrates a modification of the electronic circuit according to Figure 1, which additionally includes a low side drive circuit; and

Figure 17 illustrates one example of a tub in greater detail in which active device regions of the level shifter transistor are integrated.

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

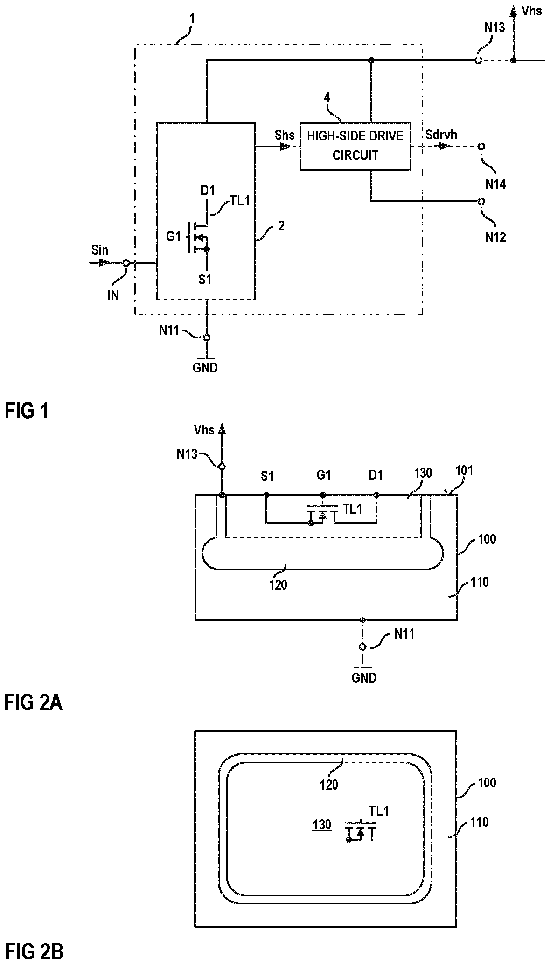

Figure 1 schematically illustrates one example of an electronic circuit 1 that includes a level shifter 2. The level shifter 2 includes a level shifter transistor TL 1 that includes a load path coupled between a low-side reference node N11 and a high-side supply node N13 of the electronic circuit 1. The load path of the level shifter transistor TL1 is a circuit path between first and second load path nodes D1, S1 of the level shifter transistor TL1. The way the load path of the level shifter transistor TL1 is connected between the low-side reference node N11 and the high-side supply node N13 is not illustrated in detail in Figure 1. Examples for connecting the load path of the level shifter transistor TL1 between the low-side reference node N11 and the high-side supply node N13 are explained herein further below.

The level shifter transistor TL1 is at least partially integrated in a semiconductor body 100. More specifically, the level shifter transistor TL1 is at least partially integrated in a device region 130 of the semiconductor body 100. The semiconductor body 100 is not illustrated in the circuit diagram shown in Figure 1.

A vertical cross-sectional view and a top view of the semiconductor body 100 including the device region 130 in which the level shifter transistor TL1 is at least partially integrated are schematically illustrated in Figures 2A-2B. According to one example, the semiconductor body 100 includes a monocrystalline semiconductor material such as, for example, silicon (Si), silicon carbide (SiC), gallium arsenide (GaAs), or gallium nitride (GaN).

The level shifter transistor TL1 is only represented by its circuit symbol in Figures 2A-2B. Just for the purpose of illustration, the level shifter transistor TL1 according to Figures 1 and 2A-2B is implemented as a MOSFET, in particular an N-type enhancement MOSFET. This, however, is only an example. Other types of transistor devices such as other types of MOSFETs, or Bipolar Junction Transistors (BJTs) may be used as well as the level shifter transistor TL1. More detailed examples of the level shifter transistor TL1 are explained herein further below.

Referring to Figures 2A and 2B, the semiconductor body 100 includes a base region 110 of a first doping type, a tub 120 of a second doping type complementary to the first to doping type, and the device region 130. The device region 130 is of the first doping type and is separated from the base region 110 by the tub 120. Furthermore, the tub 120 is connected to the high-side supply node N13 and the base region 110 is connected to the low-side reference node N11.

According to one example, a polarity of a voltage between the high-side supply node and N13 and the low-side reference node N11 and the first and second doping types are adapted to one another such that the voltage between the high-side supply node N13 and the low-side reference node N11 reverse biases a PN junction formed between the tub 120 of the second doping type and the base region 110 of the first doping type. According to one example, the voltage between the high-side supply node N13 and the low-side reference node N11 is positive, the first doping type is a P-type, and the second doping type is an N-type. In this example, the PN junction between the tub 120 and the base region 110 is reverse biased by the positive voltage between the high-side supply node N13 and the low-side reference node N11.

According to one example, the electrical potential at the low-side reference node N11 is ground GND. Thus, the low-side reference node N11 may also referred to as ground node in the following.

Referring to the above, the device region 130 is separated from the base region 110 of the semiconductor body 100 by the tub 120. Referring to Figures 2A- 2B this may include that the tub 120 completely surrounds the device region 130 in the semiconductor body 100. Examples for forming the tub 120 are explained herein further below.

According to one example illustrated in Figure 1, the electronic circuit 1 in addition to the level shifter 2 includes a high-side drive circuit 4. The level shifter 2 is configured to receive an input signal Sin at an input Iin and to provide a level-shifted control signal Shs based on the input signal Sin to the high-side drive circuit 4. The level-shifted control signal Shs, which is also referred to as high-side control signal Shs in the following, includes information included in the input signal Sin. The input signal Sin and the high-side control signal Shs are referenced to different potentials. The input signal Sin, for example, is referenced to ground GND. According to one example, the input signal Sin switches on or switches off the level shifter transistor TL1, so that the high-side control signal Shs is dependent on the switching state (on or off) of the level shifter transistor TL1. The high-side control signal Shs is referenced to a high-side supply voltage Vhs received at the high-side supply node N13, for example.

The information included in the input signal Sin and, therefore, the high-side control signal Shs is a switching information for an electronic switch, for example. According to one example, the high-side drive circuit 4 is configured to provide a drive signal Sdrvh based on the high-side control signal Shs at an output N14. The drive signal Sdrvh is also referred to as high-side drive signal Sdrvh in the following. According to one example, the drive signal Sdrvh is a voltage referenced to a high-side reference node N12.

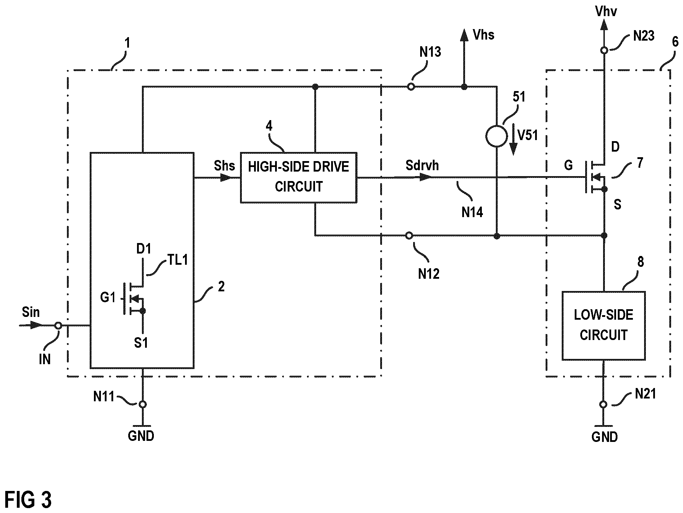

Figure 3 illustrates one example of a load circuit 6 that includes an electronic switch 7 configured to receive the high-side drive signal Sdrvh from the high-side drive circuit 4. In this example, the electronic switch 7 is a high-side switch that is connected between a load supply node N23 and a low-side circuit 8, wherein a series circuit including a load path of high-side switch 7 and the low-side circuit 8 is connected between the load supply node N23 and a load reference node N21. According to one example, the load reference node N21 and the low-side reference node N11 are connected to the same potential such as ground potential GND. The load supply node N23 is configured to receive a load supply voltage Vhv that is referenced to the load reference node N21. According to one example, the load supply voltage Vhv is selected from between several 10 V and several 100 V. A voltage blocking capability of the high-side switch 7 is selected dependent on the load supply voltage Vhv such that the high-side switch 7 is configured to withstand the load supply voltage Vhv when the high-side switch 7 is in a blocking state (switch-off state).

According to one example, the high-side switch 7 is configured to switch on or off dependent on the high-side drive signal Sdrvh received from the high-side drive circuit 4. In the on-state (switched-on-state) of the high-side switch 7 the load supply voltage Vhv essentially drops across the low-side circuit 8. In the off-state of the high-side switch 7, the load supply voltage Vhv essentially drops across the high-side switch 7.

The high-side switch 7 may be implemented as a conventional electronic switch. For illustration purposes only, the high-side switch 7 shown in Figure 3 is a MOSFET, specifically an N-type MOSFET. As is commonly known, a MOSFET is a voltage controlled device that switches on or off dependent on a drive voltage received at a drive input, wherein the drive input is formed by a gate node and a source node. Thus, in the example according to Figure 3, the high-side drive signal Sdrvh is a voltage applied between a gate node G and the source node S of the MOSFET forming the high-side switch 7. For this, the gate node G is connected to the output N14 of the electronic circuit 1 including the level shifter 2 and the high-side drive circuit 4, and the source node S is connected to the high-side reference node N12. The load path of the high-side switch 7 is a circuit path between the source node S and a drain node D of the MOSFET forming the high-side switch 7.

According to one example illustrated in Figure 3, the high-side supply voltage Vhs received at the high-side supply node N13 and referenced to the low-side reference node N11 is provided by a voltage source 51 connected between the high-side supply node N13 and the high-side reference node N12. The electrical potential at the high-side reference node N12 is dependent on the switching state of the high-side switch 7 in the load circuit 6 as follows.

When the high-side switch 7 is in the on-state, the electrical potential at the high-side reference node N12 essentially equals the load supply voltage Vhv, so that the high-side supply potential Vhs is essentially given by the load supply voltage Vhv plus the supply voltage V51 received between the high-side supply node N13 and the high-side reference node N12. When the high-side switch 7 is in the off-state, the potential at the high-side reference node N12 essentially equals ground potential GND, so that the high-side supply voltage essentially equals the voltage V51 provided by the voltage source 51 connected between the high-side supply node N13 and the high-side reference node N12.

The voltage source 51 that provides the supply voltage V51 includes a bootstrap circuit (not illustrated), for example. One example of a voltage source 51 including a bootstrap circuit is explained herein further below.

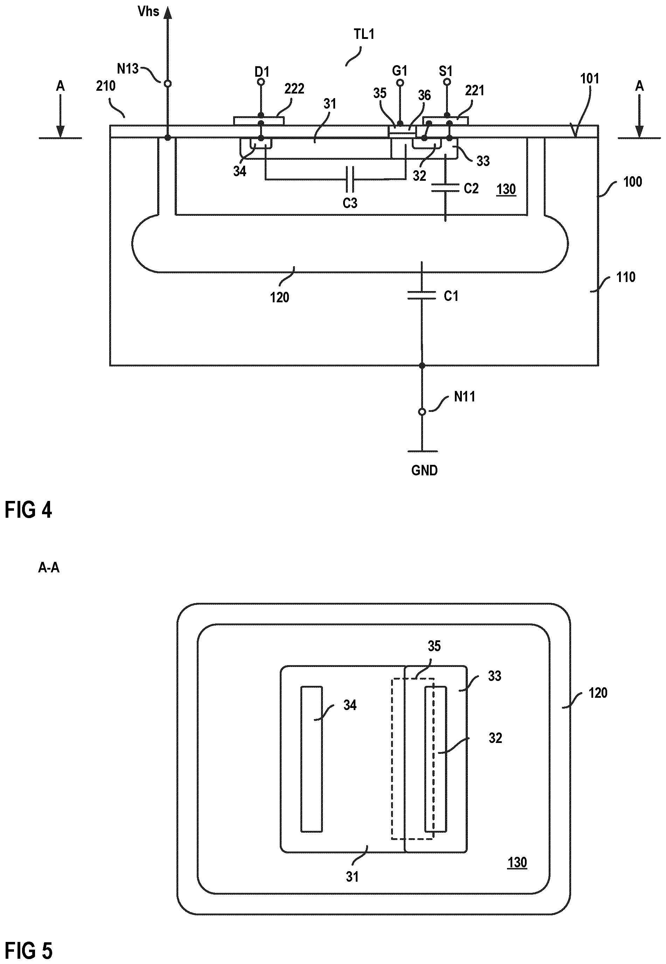

Figure 4 schematically illustrates one example for implementing the level shifter transistor TL1 in the device region 130 of the semiconductor body 100. Just for the purpose of illustration, the level shifter transistor TL1 illustrated in Figure 4 is a MOSFET. In this example, the level shifter transistor TL1 includes a drift region 31 of the second doping type, a drain region 34 of the second doping type adjoining the drift region 31, a body region 33 of the first doping type adjoining the drift region 31 and spaced apart from the drain region 34, and a source region 32 of the second doping type separated from the drift region 31 by the body region 33. Each of the drift region 31, the drain region 34, the body region 33, and the source region 32 is a doped region formed within the device region 130 of the semiconductor body 100.

The drift region 31, the source region 32, the body region 33, and the drain region 34 are also referred to as active device regions of the level shifter transistor TL1 in the following. Forming the active device regions Of the level shifter transistor TL1 may include implanting dopant atoms into the device region 130 and may include a thermal process to activate the implanted dopant atoms. The device region 130 has a basic doping of the second doping type. Referring to Figure 4, sections of the device region 130 that have the basic doping concentration remain after forming the active device regions of the level shifter transistor TL1. In the following, unless stated otherwise, "active device region 130" also denotes those sections of the active device region 130 that have the basic doping concentration after forming the active device regions of the level shifter transistor TL1.

According to one example, doping concentrations of the base region 110 and the device region 130 are selected from a range of between 1E14 cm$^{-3}$ and 1E16 cm$^{-3}$, for example. According to one example, the base region 110 and the device region 130 essentially have the same doping concentration. The doping concentration of the tub 120 is selected from between 1E18 cm$^{-3}$ and 1E20 cm$^{-3}$, for example. Doping concentrations of the source and drain regions 32, 34 are higher than 1E19 cm$^{-3}$ and lower than 1E21 cm$^{-3}$, for example. The doping concentration of the drift region 31 is selected from between 1E16 cm$^{-3}$ and 1E18 cm$^{-3}$, for example, and the doping concentration of the body region 33 is selected from between 1E17 cm$^{-3}$ and 1E19 cm$^{-3}$, for example.

Referring to Figure 4, the level shifter transistor TL1 further includes a gate electrode 35 that is adjacent to the body region 33 and is dielectrically insulated from the body region 33 by a gate dielectric 36. In a conventional way, the gate electrode 35 serves to control a conducting channel in the body region 33 between the source region 32 and the drift region 31.

The level shifter transistor TL1 is in an on-state (conducting state) in which there is a conducting channel in the body region 33 between the source region 32 and the drift region 31 when a voltage is applied between the gate electrode 35 and the source region 32 that is higher than a threshold voltage of the level shifter transistor TL1. In an N-type MOSFET, for example, the threshold voltage is a positive voltage, so that the level shifter transistor TL1 is in the on-state whenever a drive voltage higher than the threshold voltage is applied between the gate electrode 35 and the source region 32. The level shifter transistor TL1 is in an off-state (blocking state) when the voltage between the gate electrode 35 and the source region 32 is below the threshold voltage. In this operating state, the conducting channel in the body region 33 is interrupted.

According to one example, the level shifter transistor TL1 further includes a source electrode 221 connected to the source and body regions 32, 33, and a drain electrode 222 connected to the drain region 34. The source and drain electrodes 221, 222 may be spaced apart from the semiconductor body 100 and separated from the semiconductor body 100 by an insulating layer 210. Just for the purpose of illustration, the source and drain electrodes 221, 222 are drawn to be formed on top of the insulating layer 210 in the example illustrated in Figure 4. The source electrode 2021 may form a source node S1 of the level shifter transistor TL1 or may be connected to the source node S1. The drain electrode 222 may form a drain node D1 of the level shifter transistor TL1 or may be connected to the drain node D1.

Connections between the source electrode 221 and the source and body regions 32, 33 and a connection between the drain electrode 222 and the drain region 34 are only schematically illustrated in Figure 4. These connections may be implemented in a conventional way. According to one example, the connections include electrically conducting vias formed between the respective doped region 32, 33, 34 and the respective electrode 221, 222.

In the example illustrated in Figure 4, the gate electrode 35 is a planar electrode formed on top of a first surface 101 of the semiconductor body 100 and separated from the semiconductor body 100 by the gate dielectric 36. This, however, is only an example. According to another example (not illustrated) the gate electrode 35 is a trench electrode that is formed in a trench extending, in a vertical direction of the semiconductor body 100, from the first surface 101 into the semiconductor body 100 and extending, in a lateral direction of the semiconductor body 100, from the source region 32 through the body region 33 to the drift region 31. The "vertical direction" is a direction that is essentially perpendicular to the first surface 101, and the "lateral direction" is a direction that is essentially parallel to the first surface 101.

The arrangement illustrated in Figure 4 with the semiconductor body 100 and the level shifter transistor TL1 having its active device regions formed in the device region 130 separated from the base region 110 by the tub 120 includes several capacitances, that are represented by capacitor circuit symbols in Figure 4. Each of these capacitances is a junction capacitance, that is, a capacitance including a PN junction between a doped region of the first doping type and a doped region of the second doping type. Each of these capacitances is charged when a voltage is applied to the respective PN junction that reverse biases the respective PN junction, wherein the charging state of the respective capacitance varies as the magnitude of the voltage reverse biasing the PN junction varies.

Referring to Figure 4, a first capacitance C1 includes the tub 120 and the base region 110 and the PN junction formed therebetween. Due to the base region 110 being connected to the low-side reference node N11 and the tub 120 being connected to the high-side reference node N13 the first capacitance C1 is connected between the high-side reference node N13 and the low-side reference node N11. Referring to the above, the high-side supply voltage Vhs varies dependent on the switching state of the high-side switch 7 of the load circuit 6. Thus, the charging state of the first capacitance C1 varies dependent on the switching state of the high-side switch 7.

A second capacitance C2 includes the body region 33 connected to the source node S1, the device region 130, the tub 120, And the PN junction formed between the device region 130 and the tub 120. According to one example, the source node S1 is connected to the low-side reference node N11. In this example, the second capacitance C2, like the first capacitance C1, is connected between the high-side supply node N13 and the low-side reference node N11, so that the charging state of this capacitance varies dependent on the switching state of the high-side switch 7.

A third capacitance C3, which may also be referred to as drain-source capacitance of the level shifter transistor TL1, includes the drain region 34, the drift region 31, the body region 33 connected to the source node S1, sections of the device region 130 adjoining the drift region 31 and the body region 33, a PN junction formed between the body region 33 and the drift region 31, and a PN junction formed between the drift region 31 and the device region 130.

Referring to the above, the high-side control signal Shs is dependent on the switching state of the level shifter transistor TL1, wherein the switching state of the level shifter transistor is dependent on the input signal Sin. The switching speed of the level shifter 2 indicates how fast a signal level of the high-side control signal Shs changes after the signal level of the input signal Sin changes. The shorter a delay time between a change of the signal level of the input signal Sin and a corresponding change of the signal level of the high-side control signal Shs, the higher a switching speed of the level shifter 2. The input signal Sin controls the operating state of the level shifter transistor TL1, so that the switching speed of the level shifter transistor TL1 significantly governs the switching speed of the level shifter 2. The switching speed of the level shifter transistor TL1 indicates how fast the level shifter transistor TL1 changes its operating state (switching state) dependent on the input signal Sin.

The level shifter transistor TL1 can be operated in an on-state (conducting state) or an off-state (blocking state). When the level shifter transistor TL1 changes from the on-state to the off-state the conducting channel in the body region 33 is interrupted and the PN junction between the body region 33 and the drift region 31 and also the PN junction between the drift region 31 and the device region 130 is reverse biased, so that the source-drain capacitance C3 is charged. Equivalently, when the level shifter transistor TL1 changes from the off-state to the on-state, a conducting channel is generated in the body region 33 and the voltage between the body region 33 and the drift region 31 decreases so that the source-drain capacitance C3 is discharged. The switching speed of the level shifter transistor TL1 is significantly governed by how fast the source-drain capacitance C3 is charged when the level shifter transistor TL1 changes from the on-state to the off-state or is discharged when the level shifter transistor TL1 changes from the off-state to the on-state.

Referring to the above, the source-drain capacitance C3 includes the drift region 31 and portions of the device region 130 adjoining the drift region 31. Furthermore, the device region 130 is also part of the second capacitance C2 formed between the body region 33 connected to the source node S1 and the tub region 120 connected to the high-side supply node N13. The PN junction formed between the device region 130 and the tub 120 is always reverse biased, wherein the voltage reverse biasing the PN junction either essentially equals the supply voltage V51 provided by the supply voltage source 51 or equals the supply voltage V51 plus the load supply voltage Vhv. The first operating state is referred to as low-voltage state and the second operating state is referred to as high-voltage state in the following.

In each of these operating states the device region 130 is at least partially depleted of charge carriers, wherein such depletion of charge carriers of the device region 130 reduces a capacitance value of the source-drain capacitance C3. Basically, the larger the portions of the device region 130 that are depleted of charge carriers the lower the capacitance value of the source-drain capacitance C3, so that in the high voltage state the source-drain capacitance C3 is lower than in the low voltage state. Nevertheless, in both operating states, high-voltage state and low-voltage state, the partial depletion of the device region 130 that is due to connecting the tub 120 to the high-side supply node N13 and coupling the source node S1 of the level shifter transistor TL1 to the low-side reference node N11 results in a reduced capacitance value of the source-drain capacitance C3, which results in a high switching speed of the level shifter transistor TL1.

The charging state of each of the first and second capacitances C1, C2 is different in the high voltage state and the low voltage state, so that the charging state of these capacitances C1, C2 changes when the high-side supply voltage Vhs changes. The first and second capacitances C1, C2 are charged or discharged by current provided or received by the load circuit 6. The load circuit 6 is usually capable of providing a high current for changing the charging states of the first and second capacitances C1, C2 so that charging or discharging the first and second capacitances C1, C2 has no significant impact on the switching speed of the level shifter 2.

Figure 5 illustrates a top view of a transistor device of the type illustrated in Figure 4 according to one example. More specifically, Figure 5 illustrates a top view of the first surface 101 of the semiconductor body 100 in those regions in which the tub 120 and the device region 130 with the active device regions of the level shifter transistor TL1 is arranged. The position of the gate electrode 35 relative to the positions of the source, body, and drift regions 32, 33, 31 is illustrated in dashed lines in Figure 5.

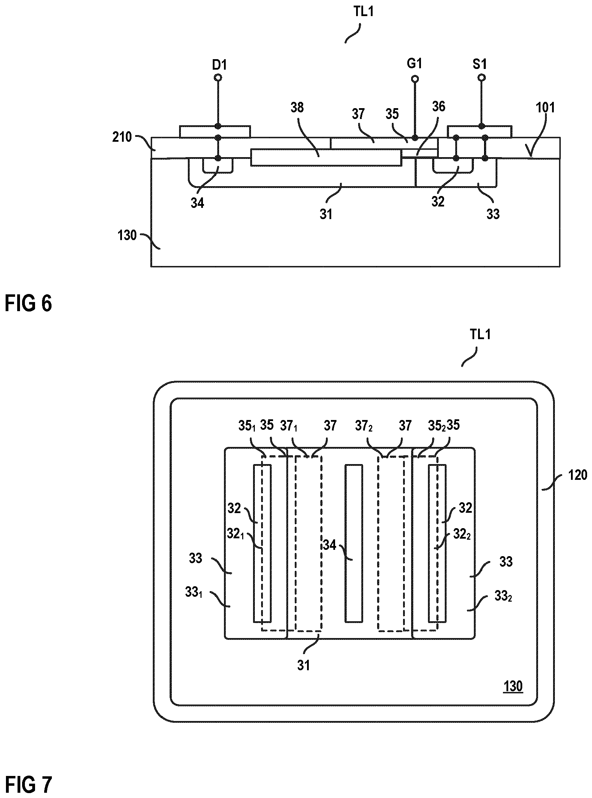

Figure 6 shows a modification of the transistor device according to Figure 4. The transistor device according to Figure 4 includes a field electrode 37 that is adjacent to the drift region 31 and dielectrically insulated from the drift region 31 by a field dielectric 38. According to one example, the gate electrode 35 and the field electrode 37 are formed by the same electrode, wherein a portion adjacent the body region 33 forms the gate electrode 35 and a portion adjacent to the drift region 31 forms the field electrode 37. According to one example, the field dielectric 38 separating the field electrode from the drift region 31 is thicker than the gate dielectric 36. According to one example, the field dielectric 38 includes a shallow trench isolation (STI) that, from the first surface 101, extends into the drift region 31. Both the gate dielectric 35 and the field dielectric 36 include an oxide, for example.

According to one example, a dimension of the field electrode 37 in the direction in which the body region 33 and the drain region 34 are spaced apart from each other is about 30%, 50%, or 70% of the distance between the body region 33 and the drain region 34.

Figure 7 illustrates a modification of a transistor device of the type illustrated in Figure 5 or Figure 6. More specifically, Figure 7 shows a top view of the device region 130 in which active device regions of the level shifter transistor TL1 is integrated.

In the example illustrated in Figure 7, the body region 33 includes two body region sections, a first body region section 331 and a second body region section 332, that are each spaced apart from the drain region 34. Furthermore, the first and second body region sections $33_1$, $33_2$ are spaced apart from each other such that the drain region 34 is arranged between the first and second body region sections $33_1$, $33_2$. According to one example, distances between the drain region 34 and the first body region section $33_1$ on one side and between the drain region 34 and the second body region section $33_2$ on the other side are essentially equal, so that the first and second body region sections $33_1$, $33_2$ are symmetrical to each other with respect to the drain region 34. Each of the first and second body region sections $33_1$, $33_2$ is connected to the source node S1 of the level shifter transistor TL1. However, connections between the first and second body region sections $33_1$, $33_2$ and the source node S1 are not illustrated in Figure 7.

Referring to Figure 7, in the transistor device according to Figure 7, the source region 32 includes a first source region section $32_1$ that is separated from the drift region 31 by the first body region section $33_1$, and a second source region section $32_2$ that is separated from the drift region 31 by the second body region section $33_2$. Each of the first and second source region sections $32_1$, $32_2$ is connected to the source node S1. However, connections between the first and second source region sections $32_1$, $32_2$ and the source node S1 are not illustrated in Figure 7.

Furthermore, in the transistor device according to Figure 7, the gate electrode 35 includes two gate electrode sections, a first gate electrode section $35_1$, and a second gate electrode section $35_2$. The first gate electrode section $35_1$ is adjacent to the first body region section $33_1$ and serves to control a first conducting channel in the first body region section $33_1$ between the first source region section $32_1$ and the drift region 31. The second gate electrode section $35_2$ is adjacent to the second body region section $33_2$ and serves to control a second conducting channel in the second body region section $33_2$ between the second source region section $32_2$ and the drift region 31. Each of the first and second gate electrode sections $35_1$, $35_2$ is connected to the gate node G1 so that the first and second conducting channel are controlled simultaneously.

Optionally, the transistor device according to Figure 7, in the same way as the transistor device according to Figure 6, includes a field electrode 37. In this example, the field electrode 37 includes a first field electrode sections $37_1$ adjoining the first gate electrode section $35_1$, and a second field electrode sections $37_2$ adjoining the second gate electrode section $35_2$.

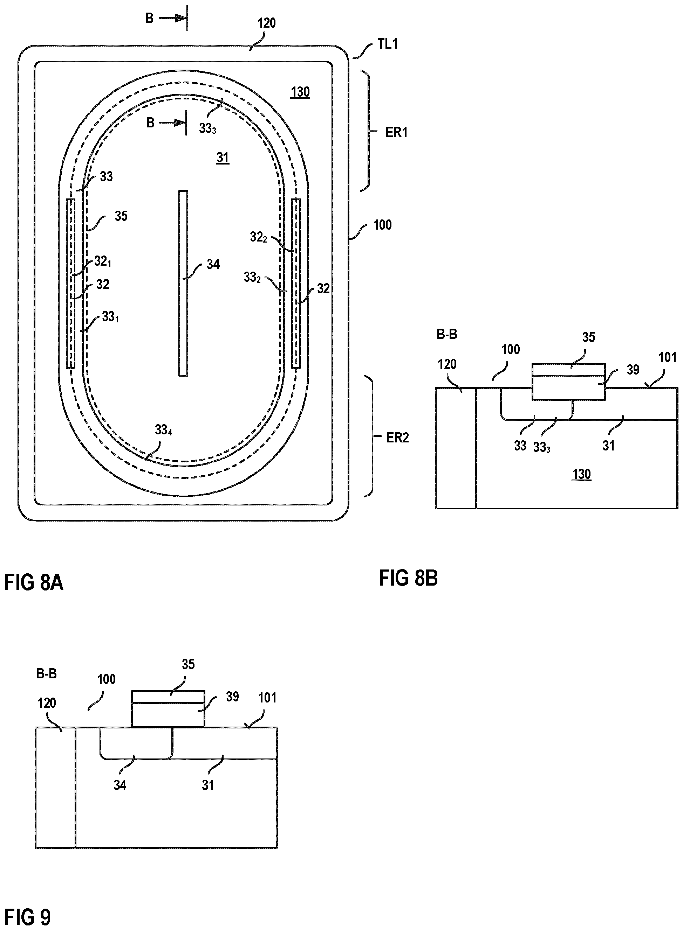

Figures 8A-8B illustrate a modification of the transistor device according to Figure 7, wherein Figure 8A shows a top view of the device region 130 in which the active device regions of the level shifter transistor TL1 are integrated, and Figure 8B shows a vertical cross-sectional view of one section of the level shifter transistor TL1 according to Figure 8A. The transistor device according to Figures 8A-8B is different from the transistor device according to Figure 7 in such a way that the body region 33, in a horizontal plane of the semiconductor body 100, forms a ring that surrounds the drift region 31 and the drain region 34. According to one example, the body region 33 is formed such that at each position of the body region 33 a (shortest) distance between the body region 33 and the drain region 34 is essentially the same.

Referring to Figure 8A, the body region 33 includes first and second body regions sections $33_1$, $33_2$ of the type explained with reference to Figure 7. That is, the first body region section $33_1$ separates a first source region section 321 from the drift region 31, and the second body region section $33_2$ separates a second source region section $32_2$ from the drift region 31. Furthermore, the first and second body region sections $33_1$, $33_2$ are spaced apart from the drain region 34 on opposite sides of the drain region 34.

Furthermore, referring to Figure 8A, the body region 33 includes a third body region section 33s arranged between the first and second body region section $33_1$, $33_2$ in a first edge region ER1 of the device region 130, and a fourth body region section $33_4$ arranged between the first and second body region sections $33_1$, $33_2$ in a second edge region ER2 of the device region 130. The third and fourth body region sections $33_3$, $33_4$ our devoid of source region sections. Furthermore, the first, second, third, and fourth body region sections $33_1$, $33_2$, $33_3$, $33_4$ form a closed loop of the body region 33 around the drift and drain regions 31, 34.

According to one example illustrated in Figure 8A, the gate electrode 35, in a way similar to the body region 33, is ring-shaped and, above the first surface 101, forms a closed loop around projections of the drift and drain regions 31, 34. In the first and second body region sections $33_1$, $33_2$, the gate electrode 35 is dielectrically insulated from the body region 33 by the gate dielectric 36 (out of view in Figure 8A). According to one example, in the edge regions ER1, ER2 the gate electrode 35 is separated from the semiconductor body 100 by a dielectric layer 39 that is thicker than the gate dielectric 36. This dielectric layer 39 is also referred to as field dielectric in the following.

Figure 8B illustrates a vertical cross-sectional view of the level shifter transistor TL1 in the first edge region ER1. More specifically, Figure 8B shows a vertical cross-sectional view of one section of the body region 33, the drift region 31, the gate electrode 35, and the field dielectric 39. The field dielectric 39 is a shallow trench isolation (STI), for example and may extend from the first surface 101 into the semiconductor body 100.

According to another example illustrated in Figure 9, the field dielectric 39 is formed on top of the first surface 101 of the semiconductor body 100.

The thickness of the field dielectric 39 is at least 5 times the thickness of the gate dielectric 36, for example. According to one example, the thickness of the field dielectric 39 is less than 100 times the thickness of the gate dielectric 36. According to one example, the thickness of the field dielectric 39 is between 5 times and 30 times the thickness of the gate dielectric 36.

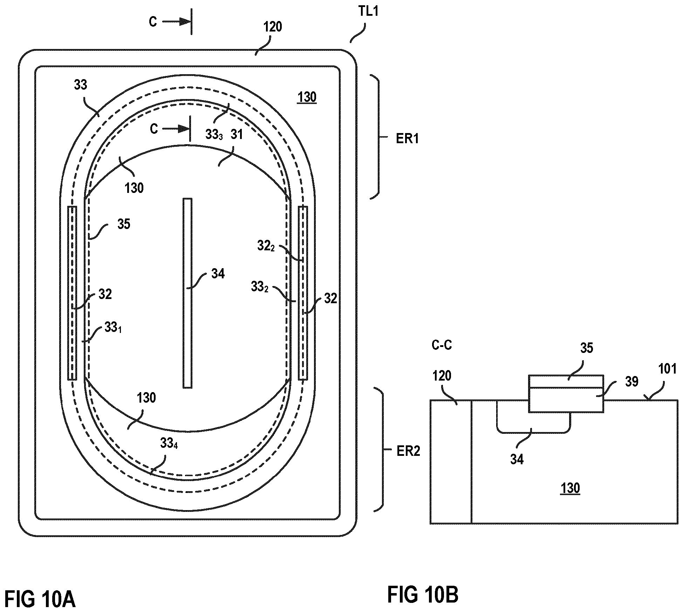

Figures 10A-10B show a modification of the level shifter transistor TL1 according to Figures 9A-9B. Figure 10A shows a top view of the device region 130 and the active device regions of the level shifter transistor TL1, and Figure 10B shows a vertical cross-sectional view of the level shifter transistor TL1 in a section of the first edge region ER1.

In the level shifter transistor TL1 according to Figures 10A-10B, the drift region 31 is spaced apart from the third and fourth body region sections $33_3$, $33_4$, so that sections of the device region 130 are arranged between each of the third and fourth body region sections $33_3$, $33_4$ and the drift region 31. Thus, in the transistor device according to Figures 10A-10B an overall size of the drift region 31 in a lateral plane of the semiconductor body 100 is lower than in the transistor device according to Figure 8A-8B. Consequently, an area of the PN junction formed between the drift region 31 and the device region 130 is smaller in the transistor device according to Figures 10A-10B as compared to the transistor device according to Figures 8A-8B. Thus, the level shifter transistor TL1 according to Figures 10A-10B has a lower source-drain capacitance C3 than the level shifter transistor according to Figures 8A-8B, so that the level shifter transistor TL1 according to Figures 10A-10B, in particular in the low-voltage state, has a higher switching speed than the level shifter transistor TL1 according to Figures 8A-8B.

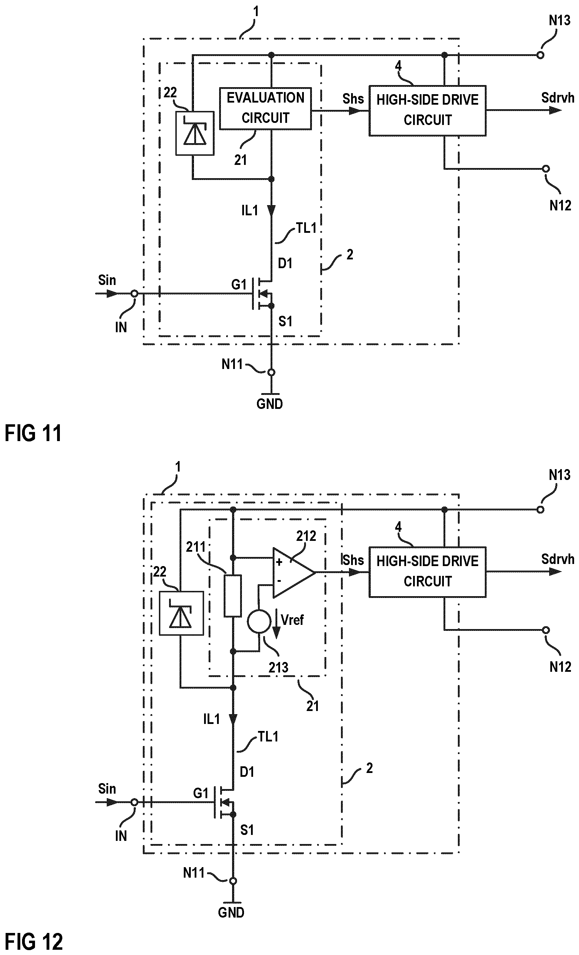

Referring to the above, the level shifter 2 includes the level shifter transistor TL1 having its load path coupled between the high-side supply node N13 and the low-side reference node N11. An example for coupling the load path of the level shifter transistor TL1 between the high-side supply node N13 and the low-side reference node N11 is illustrated in Figure 11. In this example, the level shifter 2 includes an evaluation circuit 21 that is connected in series with the load path of the level shifter transistor TL1, wherein the series circuit including the level shifter transistor TL1 and the evaluation circuit 21 is connected between the high-side supply node N13 and the low-side reference node N11.

According to one example, a voltage limiting element 22 is connected in parallel with the evaluation circuit 21. The voltage limiting circuit 22 is configured to limit (clamp) a voltage across the evaluation circuit 21, so that the voltage across the evaluation circuit does not exceed a predefined voltage threshold.. The voltage limiting circuit 22 includes a Zener diode or a series circuit including several Zener diodes connected in series, for example. The voltage threshold (clamping voltage) is selected from between several volts, such as 3V, and 20V, for example.

The evaluation second 21 is configured to detect the operating state (switching state) of the level shifter transistor TL1 and generate the high-side control signal Shs dependent on the detected switching state of the level shifter transistor TL1. According to one example, the evaluation circuit 21 is configured to monitor a transistor current IL1 through the level shifter transistor TL1 and generate the high-side control signal Shs dependent on a detected current level of the transistor current IL 1. According to one example, the evaluation circuit 21 is configured to generate the high-side control signal Shs such that the high-side control signal Shs has a first signal level when the monitored current IL1 indicates that the level shifter transistor TL1 is in the on-state and a second signal level when the monitored current IL1 indicates that the level shifter transistor TL1 is in the off-state.

One example of an evaluation circuit 21 that is configured to monitor the transistor current IL1 and generate the high-side control signal Shs dependent on monitored transistor current IL1 is illustrated in Figure 12. In the example illustrated in Figure 12, the evaluation circuit 21 includes a resistor 211 that is connected in series with the load path of the level shifter transistor TL1. A comparator 212 compares a voltage V211 across the resistor 211 with a reference voltage Vref provided by a reference voltage source 213, and generates the high-side control signal Shs dependent on a relationship between the voltage V211 across the resistor 211 and the reference voltage Vref. According to one example, the comparator 212 generates the high-side control signal Shs to have a first signal level when the voltage V211 across the resistor 211 is higher than the reference voltage Vref and to have a second signal level when the voltage V211 across the resistor 211 is lower than the reference voltage. According to one example, the first signal level is a high signal level and the second signal level is a low signal level.

The voltage across the resistor 211 is given by a resistance R211 of the resistor 211 multiplied with a current level of the transistor current IL1,

$$V211 = R211 \cdot IL1 \qquad (1),$$

where R211 denotes the resistance of the resistor 211 and IL1 denotes the current level of the transistor current. Thus, the comparator 212 switches the high-side control signal Shs from the first signal level to the second signal level when the monitored current IL1 falls below a current threshold IL1th that is dependent on the resistance R211 and the reference voltage Vref as follows:

$$IL1th = \frac{Vref}{R211} \qquad (2).$$

Equivalently, the comparator switches the high-side control signal Shs from the second signal level to the first signal level when the monitored current IL1 rises above the current threshold IL1th according to equation (2).

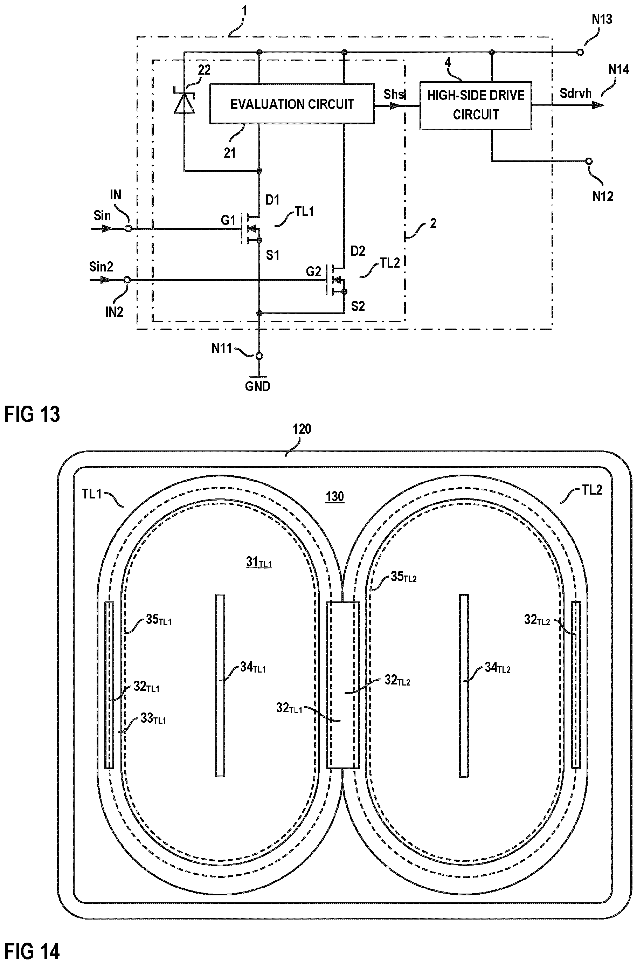

Figure 13 shows a modification of the level shifter 2 according to Figure 11. In the example illustrated in Figure 13, the level shifter 2, in addition to the level shifter transistor TL1, includes a further level shifter transistor TL2 having a load path coupled between the high-side supply node N13 and the low-side reference node N11. In the following, level shifter transistor TL1 is referred to as first level shifter transistor and further level shifter transistor TL2 is referred to as second level shifter transistor.

Referring to Figure 13, each of the first and second level shifter transistors TL1, TL2 is connected in series with the evaluation circuit 21. Just for the purpose of illustration, each of the first and second level shifter transistors TL1, TL2 is implemented as a MOSFET, specifically as an N-type MOSFET. Source nodes S1, S2 of the two level shifter transistors are connected to the low-side reference node N11, and drain nodes D1, D2 of the level shifter transistors TL1, TL2 are connected to the evaluation circuit 21. Level shifter transistor TL1 is referred to as first level shifter transistor, and the further level shifter transistor TL2 is referred to as second level shifter transistor in the following. equivalently, input signal Sin configured to control the operating state of the first level shifter transistor TL1 is referred to as first input signal, and an input signal Sin2 configured to control the operating state of the second level shifter transistor TL2 is referred to as second level shifter transistor in the following. Each of the first and second input signals Sin, Sin2 is configured to switch on or off the respective level shifter transistor TL1, TL2.

The evaluation circuit 21 is configured to detect the operating state of each of the first and second level shifter transistors TL1, TL2 and generate the high-side control signal Shs dependent on the operating states of the first and second level shifter transistors TL1, TL2. According to one example, the first and second level shifter transistors TL1, TL2 are operated in a complementary (differential) fashion such that, at each time, one of the first and second level shifter transistors TL1, TL2 is in the on-state and the other one of the first and second level shifter transistors TL1, TL2 is in the off-state. In this example, the evaluation circuit 21 is configured to generate the signal level of the high-side control signal Shs dependent on which of the first and second level shifter transistors TL1, TL2 is in the on-state and which of the first and second level shifter transistors TL1, TL2 is in the off-state.

According to one example, active device regions of the first and second level shifter transistors TL1, TL2 are integrated in the same device region 130. This is illustrated in Figure 14, which shows a top view of the device region 130 in which active device regions of the first and second level shifter transistors TL1, TL2 are integrated.

n the example illustrated in Figure 14, each of the first and second level shifter transistors is implemented in accordance with the example illustrated in Figure 8A. This, however, is only an example. According to another example (not illustrated), each of the first and second level shifter transistors is implemented in accordance with the example illustrated in Figure 10A.

In the example illustrated in Figure 14, the individual parts (features) of the first and second level shifter transistors TL1, TL2 have the same reference numbers as in the example illustrated in Figure 8A, wherein subscript "TL1" has been added to the reference numbers of the first level shifter transistor TL1and subscript "TL2" has been added to the reference numbers of the second level shifter transistor TL2.

Referring to Figure 14, the ring-shaped body regions $33_{TL1}$, $33_{TL2}$ of the first and second level shifter transistors TL1, TL2 may adjoin each other or may be partially emerged, so that the body region body regions $33_{TL1}$, $33_{TL2}$ form a contiguous doped semiconductor region. The source regions $32_{TL1}$, $32_{TL2}$ may be formed by the same doped semiconductor region and be connected to a common source node forming the source node S1 the first level shifter transistor TL1 and the source node S2 of the second level shifter transistor TL2 at the same time.

It should be noted that the level shifter 2 is not restricted to be implemented with one or two level shifter transistors. According to another example (not illustrated), the level shifter 2 includes at least one further level shifter transistors each having its load path coupled between the high-side reference node N13 and the low-side reference node N11. The operating state of the further level shifter transistor is controlled by a further input signal. The at least one further level shifter transistor may be used to transmit further information from a control circuit generating the further input signal to the evaluation circuit, wherein this further information may be transmitted from the evaluation circuit 21 to the high-side drive circuit 4.

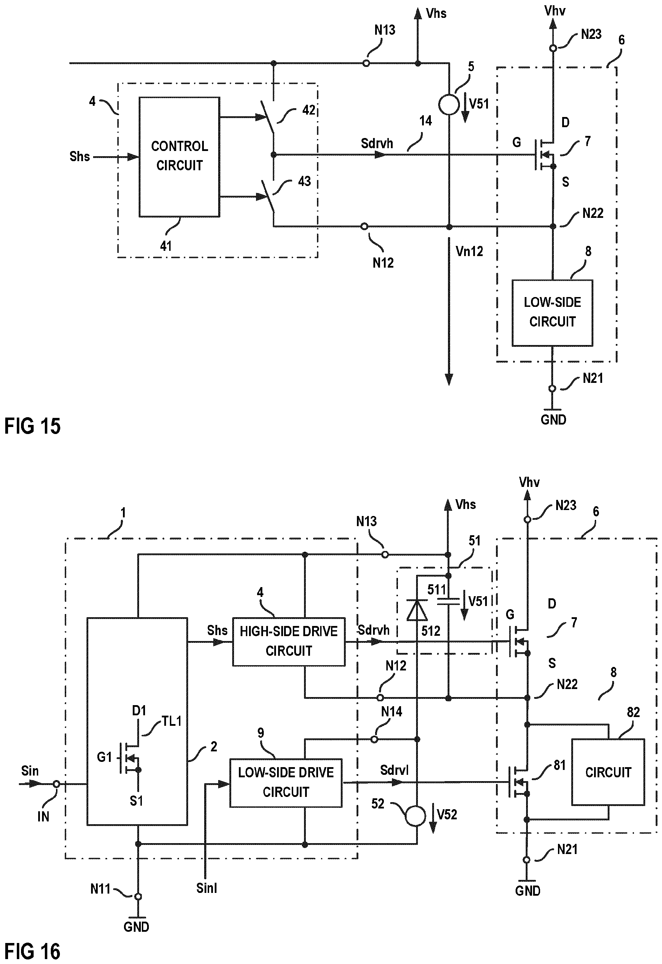

Figure 15 illustrates one example of the high-side control circuit 4. In this example, the high-side control circuit 4 includes a control circuit 41 configured to receive the high-side control signal Shs and a half bridge. The half-bridge includes a first switch 42 connected between the high-side supply node N13 and the output 14 of the high-side drive circuit 4, and a second switch 43 connected between the output 14 and the high-side reference node N12. Each of the first and second switches 42, 43 is controlled by the control circuit 41 dependent on the high-side control signal Shs.

The control circuit 41 is configured to control operation of the first and second switches 42, 43 in a complementary fashion, so that at each time only one of the first and second switches 42, 43 is switched on. To switch on the high-side switch 7, the control circuit 41, dependent on the high-side control signal Shs, switches on the first switch 42, so that the drive voltage (gate-source voltage) of the high-side switch 7 essentially equals the supply voltage V51 which is suitable to switch on the high-side switch 7. To switch off the high-side switch 7, the control circuit 41 switches on the second switch 43, so that the drive voltage of the high-side switch 7 essentially equals zero, which switches off the high-side switch 7.

Figure 16 illustrates one example of the low-side circuit 8 and a drive circuit configured to control operation of the low-side circuit 8. In the example illustrated in Figure 16, the low-side circuit 8 includes a low-side switch 81 connected in series with the high-side switch 7. More specifically, a load path of the low-side switch 81 is connected in series with the load path of the high-side switch 7. According to one example, an electronic circuit 82 is connected in parallel with the low-side switch 81. This circuit 82 may be implemented in various ways. According to one example, the electronic circuit 82 includes circuit elements, such as inductors or capacitors, which, in combination with the high-side switch 7 and the low-side switch 81, form a power converter such as, for example, a buck converter, a boost converter, or the like.

The operating state of the low-side switch 81 is controlled by a low-side drive circuit 9 which is part of the electronic circuit 1. Just for the purpose of illustration, the low-side switch 81 according to Figure 16 is a MOSFET, more specifically, an N-type MOSFET. The low-side switch 81 switches on or off dependent on a drive signal Sdrvl generated by the low-side drive circuit 9. The low-side drive circuit 9 is configured to generate the low-side drive signal Sdrvl dependent on a respective input signal Sinl received by low-side drive circuit 9.

The low-side drive circuit 9 may be implemented similar to the high-side drive circuit illustrated in Figure 15. For generating the low-side drive signal Sdrvl the low-side drive circuit 9 receives a low-side supply voltage V52 from a low-side voltage source 52.

According to one example illustrated in Figure 16, the voltage source 51 providing the supply voltage V51 to the high-side drive circuit 4 includes a bootstrap circuit that is coupled to the low-side voltage source 52 and includes a capacitor 511 connected between the high-side supply node N13 and the high-side reference node N12. Furthermore, the bootstrap circuit includes a diode 512 connected between the capacitor 511 and the low-side voltage source 52. In this example, the capacitor 511 is charged by the low-side voltage source 52 each time the low-side switch 81 is in the on-state. The low-side supply voltage V52 is referenced to ground, so that the capacitor 511 is charged each time the high-side reference node N12 essentially equals ground GND due to the low-side switch 8 being in the on-state.

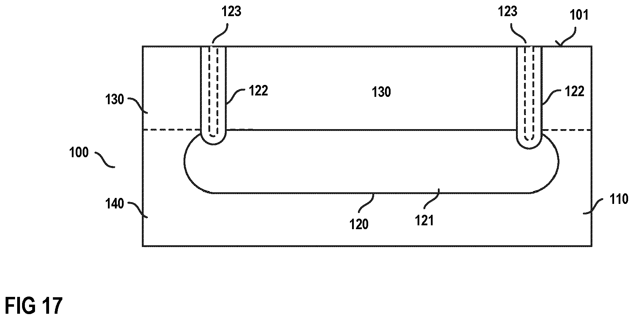

Figure 7 illustrates one example of the tub 120 in greater detail. The level shifter transistor is not illustrated in Figure 17. Referring to Figure 17, the tub 120 includes a bottom portion 121 and sidewall portions 122 extending from the bottom portion 121 to the first surface 101 of the semiconductor body 100, so that the bottom portion 121 and the sidewall portions 122 surround the device region 120 within the semiconductor body 100.

Forming a tub 120 of the type illustrated in Figure 17 may include providing a first layer 140 of the semiconductor body 100 and implanting dopant atoms into a surface of the first layer 142 to form the bottom region 121. The first layer 140 may include a semiconductor substrate having a basic doping of the base region 110, or may include a substrate and an epitaxial layer formed on top of the substrate.

Forming the tub 120 may further include forming a second layer 150 on top of the first layer 140 of the semiconductor body 100 and forming the sidewall portions 122 in the second layer 150. Forming the sidewall portions 120 may include implanting dopant atoms via the first surface 101 of the semiconductor body 100 into those regions in which the sidewall portions 122 are to be formed.

According to another example, the second layer 150 includes several sub-layers, wherein after forming each of these sub-layers dopant atoms are implanted into the respective sub-layer to form doped regions. The doped regions in the sub-layers together form the sidewall portions 122 of the top 120.

According to another example, illustrated in dashed lines in Figure 17, trenches are formed in the first surface 101 after forming the second layer 150 and the trenches are filled with a material including dopant atoms and acting as a dopant source. The dopant source is a silicate glass, for example. The method further includes diffusing dopant atoms from the dopant source into surrounding semiconductor regions to form the doped regions forming the sidewall portions 122. The dopant source may be removed from the trenches after the diffusion process and replaced by a filling material, or may remain in the trenches.

It should be noted that in addition to the level shifter 2 with the one or more level shifter transistors TL1, TL2 further portions of the electronic circuit 1 may be Integrated in the semiconductor body 100. According to one example, the high-side drive circuit 4 is also integrated in the semiconductor body 100. According to another example, the high-side drive circuit 4 and the low-side drive circuit 9 are integrated in the semiconductor body 100.

Some of the examples explained above are briefly summarized in the following with reference to numbered examples.

Example 1. An electronic circuit, comprising: a level shifter comprising a level shifter transistor having a load path coupled between a low-side reference node and a high-side supply node of the electronic circuit, wherein the electronic circuit further comprises a semiconductor body having a base region of a first doping type, a tub of a second doping type complementary to the first doping type, and a device region of the first doping separated from the base region by the tub, wherein the level shifter transistor is at least partially integrated in the device region, and wherein the tub is connected to the high-side supply node and the base region is connected to the low-side reference node.

Example 2. The electronic circuit of example 1, wherein the level shifter transistor comprises: a drift region of the second doping type; a drain region of the second doping type adjoining the drift region; a body region of the first doping type adjoining the drift region spaced apart from the drain region; a source region of the second doping type separated from the drift region by the body region; and a gate electrode adjacent to the body region and dielectrically insulated from the body region by a gate dielectric.

Example 3. The electronic circuit of example 2, wherein the drain region is embedded in the drift region, wherein the body region comprises a first body region section that is spaced apart from the drain region in a first lateral direction of the semiconductor body, and a second body region section that is spaced apart from the drain region in a second lateral direction opposite the first lateral direction, and wherein the source region comprises a first source region section arranged in the first body region section, and a second source region section arranged in the second body region section.

Example 4. The electronic circuit of example 3, wherein the first and second source region sections are spaced apart from each other, and wherein the body region, in a horizontal plane of the semiconductor body, forms a closed loop around the drain region.

Example 5. The electronic circuit of example 4, wherein the body region comprises a third body region section arranged between the first and second body region sections in a first edge region of the level shifter transistor, wherein the body region comprises a fourth body region section arranged between the first and second body region sections in a second edge region of the level shifter transistor, and wherein the drift region adjoins both the third and fourth body region sections.

Example 6. The electronic circuit of example 4, wherein the body region comprises a third body region section arranged between the first and second body region sections in a first edge region of the level shifter transistor, wherein the body region comprises a fourth body region section arranged between the first and second body region sections in a second edge region of the level shifter transistor, and wherein the drift region is spaced apart from at least one of the third and fourth body region sections.

Example 7. The electronic circuit of examples 5 and 6, wherein the gate electrode is arranged on top of the third and fourth body region sections and is dielectrically insulated from the third and fourth body region sections by a field dielectric.

Example 8. The electronic circuit of any one of examples 2 to 7, wherein the drift region is separated from the tub by the device region.

Example 9. The electronic circuit of any one of examples 1 to 8, wherein the level shifter transistor is a first level shifter transistor, and wherein the level shifter comprises at least one further level shifter transistor having a load path coupled between the low-side reference node and the high-side supply node of the electronic circuit, and wherein the at least one further level shifter transistor is at least partially integrated in the device region.

Example 10. The electronic circuit of any one of examples 1 to 9, wherein the level shifter further comprises: an evaluation circuit connected in series with the level shifter transistor and connected between the level shifter transistor and the high-side supply node.

Example 11. The electronic circuit of example 10, wherein the level shifter further comprises: a voltage clamping element connected in parallel with the evaluation circuit.

Example 12. The electronic circuit of example 10 or 11, wherein the evaluation circuit is at least partially integrated in the semiconductor body.

Example 13. The electronic circuit of any one of examples 10 to 12, further comprising: a high-side drive circuit connected to the evaluation circuit and configured to receive a high-side control signal from the evaluation circuit and drive a high-side transistor device dependent on the high-side control signal.

Example 14. The electronic circuit of example 13, wherein the high-side drive circuit is at least partially integrated in the semiconductor body.

Example 15. An integrated circuit, comprising: a semiconductor body having a base region of a first doping type, a tub of a second doping type complementary to the first doping type, and a device region of the first doping separated from the base region by the tub; and a transistor at least partially integrated in the device region, wherein the transistor comprises: a drift region of the second doping type; a drain region of the second doping type adjoining the drift region; a body region of the first doping type adjoining the drift region spaced apart from the drain region; a source region of the second doping type separated from the drift region by the body region; and a gate electrode adjacent to the body region and dielectrically insulated from the body region by a gate dielectric, and wherein the body region, in a horizontal plane of the semiconductor body, forms a closed loop around the drain region, and wherein the drift region is spaced apart from the body region in at least one of a first and second edge region of the transistor.

Example 16. The integrated circuit of example 15, wherein the device region is arranged between the drift region and the body region in the at least one of the first and second edge regions of the transistor.

Example 17. The integrated circuit of example 15, wherein a doped region of the second doping type and having a lower doping concentration than the drift region is arranged between the drift region and the body region in the at least one of the first and second edge regions of the transistor.

Example 18. The integrated circuit of any one of examples 15 to 17, wherein the body region comprises a first body region section that is spaced apart from the drain region in a first lateral direction of the semiconductor body, and a second body region section that is spaced apart from the drain region in a second lateral direction opposite the first lateral direction, and wherein the source region comprises a first source region section arranged in the first body region section, and a second source region section arranged in the second body region section, wherein the body region further comprises a third body region section arranged between the first and second body region sections in the first edge region of the transistor, and wherein the body region comprises a fourth body region section arranged between the first and second body region sections in a second edge region of the transistor.

Example 19. The electronic circuit of any one of examples 15 to 18, wherein the drift region is separated from the tub by the device region.

**Claims**

1.   An electronic circuit, comprising:

a level shifter (2) comprising a level shifter transistor (TL1) having a load path coupled between a low-side reference node (N11) and a high-side supply node (N13) of the electronic circuit (1),
wherein the electronic circuit further comprises a semiconductor body (100) having a base region (110) of a first doping type, a tub (120) of a second doping type complementary to the first doping type, and a device region (130) of the first doping separated from the base region (110) by the tub (120),
wherein the level shifter transistor (TL1) is at least partially integrated in the device region (130), and
wherein the tub (120) is connected to the high-side supply node (N13) and the base region (110) is connected to the low-side reference node (N11).

2.   The electronic circuit of claim 1,
wherein the level shifter transistor (TL1) comprises:

a drift region (31) of the second doping type;
a drain region (34) of the second doping type adjoining the drift region (31);
a body region (33) of the first doping type adjoining the drift region (31) spaced apart from the drain region (34);
a source region (32) of the second doping type separated from the drift region (31) by the body region (33); and
a gate electrode (35) adjacent to the body region (33) and dielectrically insulated from the body region (33) by a gate dielectric (36).

3.   The electronic circuit of claim 2,

wherein the drain region (34) is embedded in the drift region (31),
wherein the body region (33) comprises a first body region section ($33_1$) that is spaced apart from the drain region (34) in a first lateral direction of the semiconductor body (100), and a second body region section ($33_2$) that is spaced apart from the drain region (34) in a second lateral direction opposite the first lateral direction, and
wherein the source region (32) comprises a first source region section ($32_1$) arranged in the first body region section ($33_1$), and a second source region section ($32_2$) arranged in the second body region section ($33_2$).

4.   The electronic circuit of claim 3,

wherein the first and second source region sections ($32_1$, $32_2$) are spaced apart from each other, and
wherein the body region (33), in a horizontal plane of the semiconductor body (100), forms a closed loop around the drain region (34).

5.   The electronic circuit of claim 4,

wherein the body region (33) comprises a third body region section ($33_3$) arranged between the first and second body region sections ($33_1$, $33_2$) in a first edge region (ER1) of the level shifter transistor (TL1),
wherein the body region (33) comprises a fourth body region section ($33_4$) arranged between the first and second body region sections ($33_1$, $33_2$) in a second edge region (ER2) of the level shifter transistor (TL1), and
wherein the drift region (21) adjoins both the third and fourth body region sections ($33_3$, $33_4$).

6.   The electronic circuit of claim 4,

wherein the body region (33) comprises a third body region section ($33_3$) arranged between the first and second body region sections ($33_1$, $33_2$) in a first edge region (ER1) of the level shifter transistor (TL1),
wherein the body region (33) comprises a fourth body region section ($33_4$) arranged between the first and second body region sections ($33_1$, $33_2$) in a second edge region (ER2) of the level shifter transistor (TL1), and
wherein the drift region (21) is spaced apart from at least one of the third and fourth body region sections ($33_3$, $33_4$).

7.  The electronic circuit of any one of claims 2 to 6,
    wherein the drift region (21) is separated from the tub (120) by the device region (130).

8.  The electronic circuit of any one of the preceding claims,

    wherein the level shifter transistor (TL1) is a first level shifter transistor, and
    wherein the level shifter (2) comprises at least one further level shifter transistor (TL2) having a load path coupled between the low-side reference node (N11) and the high-side supply node (N13) of the electronic circuit (1), and
    wherein the at least one further level shifter transistor (TL2) is at least partially integrated in the device region (130).

9.  The electronic circuit of any one of the preceding claims, wherein the level shifter (2) further comprises:
    an evaluation circuit connected in series with the level shifter transistor (TL1) and connected between the level shifter transistor (TL1) and the high-side supply node (N13).

10. The electronic circuit of claim 9, wherein the level shifter (2) further comprises:
    a voltage clamping element (22) connected in parallel with the evaluation circuit.

11. The electronic circuit of any one of claims 9 to 10, further comprising:
    a high-side drive circuit (4) connected to the evaluation circuit (21) and configured to receive a high-side control signal (Shs) from the evaluation circuit (21) and drive a high-side transistor (7) device dependent on the high-side control signal (Shs).

12. An integrated circuit, comprising:

    a semiconductor body (100) having a base region (110) of a first doping type, a tub (120) of a second doping type complementary to the first doping type, and a device region (130) of the first doping separated from the base region (110) by the tub (120); and
    a transistor (TL1) at least partially integrated in the device region (130),
    wherein the transistor (TL1) comprises:

    a drift region (31) of the second doping type;
    a drain region (34) of the second doping type adjoining the drift region (31);
    a body region (33) of the first doping type adjoining the drift region (31) spaced apart from the drain region (34);
    a source region (32) of the second doping type separated from the drift region (31) by the body region (33); and
    a gate electrode adjacent to the body region (33) and dielectrically insulated from the body region (33) by a gate dielectric (36), and
    wherein the body region (33), in a horizontal plane of the semiconductor body (100), forms a closed loop around the drain region (34), and
    wherein the drift region (21) is spaced apart from the body region (33) in at least one of a first and second edge region (ER1, ER2) of the transistor (TL1).

13. The integrated circuit of claim 12,
    wherein the device region (130) is arranged between the drift region (21) and the body region (33) in the at least one of the first and second edge regions (ER1, ER2) of the transistor (TL1).

14. The integrated circuit of claim 12,
    wherein a doped region of the second doping type and having a lower doping concentration than the drift region (21) is arranged between the drift region (21) and the body region (33) in the at least one of the first and second edge regions (ER1, ER2) of the transistor (TL1).

15. The integrated circuit of any one of claims 12 to 14,

wherein the body region (33) comprises a first body region section ($33_1$) that is spaced apart from the drain region (34) in a first lateral direction of the semiconductor body (100), and a second body region section ($33_2$) that is spaced apart from the drain region (34) in a second lateral direction opposite the first lateral direction, and wherein the source region (32) comprises a first source region section ($32_1$) arranged in the first body region section ($33_1$), and a second source region section ($32_2$) arranged in the second body region section ($33_2$), wherein the body region (33) further comprises a third body region section (33s) arranged between the first and second body region sections ($33_1$, $33_2$) in the first edge region (ER1) of the transistor (TL1), and wherein the body region (33) comprises a fourth body region section ($33_4$) arranged between the first and second body region sections ($33_1$, $33_2$) in a second edge region (ER2) of the transistor (TL1).

FIG 1

FIG 2A

FIG 2B

FIG 3

FIG 4

A-A

FIG 5

**FIG 6**

**FIG 7**

FIG 8A

FIG 8B

FIG 9

**FIG 10A**

**FIG 10B**

FIG 11

FIG 12

**FIG 13**

**FIG 14**

**FIG 15**

**FIG 16**

FIG 17

Europäisches
Patentamt

European
Patent Office

Office européen
des brevets

# EUROPEAN SEARCH REPORT

**Application Number**

EP 23 21 5319

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 7 345 340 B2 (RENESAS TECH CORP [JP]) 18 March 2008 (2008-03-18) * column 5, line 55 - column 9, line 52; figures 1-6,9 * | 1 | INV. H01L29/06 H01L21/761 H01L29/10 H01L29/423 |
| X | US 10 002 961 B2 (FUJI ELECTRIC CO LTD [JP]) 19 June 2018 (2018-06-19) | 1,2,7-11 | H01L29/78 |
| Y | * column 8, line 20 - column 18, line 37; figure 7 * | 3-5 | |
| X | US 2016/329425 A1 (ICHIKAWA DAISUKE [JP]) 10 November 2016 (2016-11-10) | 12-15 | |
| Y | * paragraphs [0054] - [0113]; figures 1-12 * | 3-5 | |

**TECHNICAL FIELDS SEARCHED (IPC)**

H01L

The present search report has been drawn up for all claims

| Place of search | Date of completion of the search | Examiner |
|---|---|---|
| Munich | 5 August 2024 | Götz, Andreas |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

Europäisches
Patentamt

European
Patent Office

Office européen
des brevets

**Application Number**

EP 23 21 5319

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☒ Only part of the further search fees have been paid within the fixed time limit. The present European search report has been drawn up for those parts of the European patent application which relate to the inventions in respect of which search fees have been paid, namely claims:

1-5, 7-15

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**
**SHEET B**

Application Number

EP 23 21 5319

The Search Division considers that the present European patent application does not comply with the requirements of unity of invention and relates to several inventions or groups of inventions, namely:

    1. claims: 1-5, 7-11

        Level shifter with tub connected to high-side
                        - - -

    2. claims: 12-15

        Integrated circuit with a body region forming a closed loop
        around the drain region
                        - - -

    3. claim: 6

        Drift region spaced apart from body region sections
                        - - -

**EP 4 567 895 A1**

## ANNEX TO THE EUROPEAN SEARCH REPORT
## ON EUROPEAN PATENT APPLICATION NO.

EP 23 21 5319

This annex lists the patent family members relating to the patent documents cited in the above-mentioned European search report.
The members are as contained in the European Patent Office EDP file on
The European Patent Office is in no way liable for these particulars which are merely given for the purpose of information.

05-08-2024

| Patent document cited in search report | | Publication date | Patent family member(s) | | Publication date |
|---|---|---|---|---|---|
| US 7345340 | B2 | 18-03-2008 | CN | 1773726 A | 17-05-2006 |
| | | | JP | 4545548 B2 | 15-09-2010 |
| | | | JP | 2006120818 A | 11-05-2006 |
| | | | US | 2006086973 A1 | 27-04-2006 |
| US 10002961 | B2 | 19-06-2018 | CN | 105074922 A | 18-11-2015 |
| | | | EP | 3010042 A1 | 20-04-2016 |
| | | | JP | 5994939 B2 | 21-09-2016 |
| | | | JP | WO2014199608 A1 | 23-02-2017 |
| | | | US | 2016056282 A1 | 25-02-2016 |
| | | | WO | 2014199608 A1 | 18-12-2014 |
| US 2016329425 | A1 | 10-11-2016 | NONE | | |

EPO FORM P0459

For more details about this annex : see Official Journal of the European Patent Office, No. 12/82